# EUROPEAN PATENT APPLICATION

(11) **EP 2 355 133 A2**
(43) Date of publication of application: **10.08.2011**
(21) Application number: 11000591.5
(22) Date of filing: 25.01.2011
(51) Int. Cl.: H01L 21/00

(54) **Substrate heating apparatus, substrate heating method and substrate processing system**

(30) Priority: 27.01.2010 JP 2010015600
(71) Applicant: Tokyo Electron Limited, Tokyo 107-6325 (JP)
(72) Inventor: Okubo, Tomoya, Yamanashi 407-8511 (JP); Sugiyama, Masaki, Yamanashi 407-8511 (JP)
(74) Representative: Diehl & Partner GbR

(57) **Abstract**

A substrate heating apparatus (20) includes a container configured to be maintained in a depressurized state; and a substrate mounting table (86) having a plurality of substrate support pins on its upper surface. The substrate mounting table (86) is configured to mount a substrate while providing a gap between the upper surface of the substrate mounting table (86) and the substrate. The substrate heating apparatus (20) further includes a heater (87) configured to heat the substrate through the substrate mounting table (86); a pressure regulator configured to regulate a pressure in the container; a temperature controller configured to control an output of the heater so as to control a temperature of the substrate mounting table; and a pressure controller configured to control the pressure regulator so as to control the pressure in the container.

## Description

### CROSS-REFERENCE TO RELATED APPLICATIONS

This application is based upon and claims the benefit of priority from Japanese Patent Application No. 2010-015600, filed on January 27, 2010.

### TECHNICAL FIELD

Embodiments described herein relate generally to a substrate heating apparatus and a substrate heating method for heating a substrate of, for example, a flat panel display (FPD) or a solar cell, and a substrate processing system for performing a process including a heat treatment on a substrate.

### BACKGROUND

In manufacturing a substrate of a flat panel display (FPD) or a solar cell, a film forming process that includes heat treatment is generally performed. As a system for efficiently performing such process including heat treatment, a multi-chamber type substrate processing system provided with a plurality of processing units and one or more pre-heating units is known in the prior art (for example, *See* Japanese Laid-Open Patent Publication No. 11-312727).

In such multi-chamber type substrate processing system, a substrate is heated up to an approximate process temperature in a pre-heating unit and then transferred to each of a plurality of processing units. In this case, the time required for raising the temperature in the pre-heating unit affects productivity such that it is required to raise the temperature as rapidly as possible. To prevent a substrate from being warped, it is further required to uniformly raise the temperature and to stably maintain the temperature when a predetermined temperature is reached.

As a method for rapidly heating and controlling a substrate at a predetermined temperature, the use of a heat source such as a lamp using radiant heat is known. Also, as a heating method, it is known to use heat transmission or heat conduction by mounting a substrate on a mounting table in which a resistance heater is provided as a heat source.

Among these ways of heating, the use of a lamp exploiting radiant heat can instantaneously control heat transmission such that it is possible to rapidly heat up a substrate as well as to maintain a uniform temperature stably. However, in such a case, the lamp may be very expensive so that it may be difficult to use this type of lamp as a heat source due to its cost effect on the overall price of the equipment.

In a heating manner using a resistance heater as a heat source, it may be difficult to instantaneously control heat transmission and the temperature of the heat source may be limited to be around the temperature to which a substrate should be heated. Thus, in such a case, it is difficult to secure a stable temperature due to an overshoot of the temperature. Further, from a microscopic point of view, there may be portions of a substrate that may be in contact and may be not in contact with the mounting table, thereby inducing differences in heat transmission therebetween. Thus, in this case, it is difficult to secure a temperature uniformity due to the differences of heat transmission, and as a result, a warpage of the substrate may be easily occur. Therefore, it is difficult to achieve a rapid heating of the substrate.

### SUMMARY

It is, therefore, an object of some embodiments in the present disclosure to provide a substrate heating apparatus and a substrate heating method capable of rapidly raising a temperature as well as securing a stable and uniform in-surface temperature of a substrate without increasing equipment cost.

It is another object of some embodiments of the present disclosure to provide a substrate processing system performing a process including a heat treatment on the substrate by using a substrate heating apparatus.

In accordance with a first aspect of the present disclosure, a substrate heating apparatus is provided. The substrate heating apparatus includes a container configured to be maintained in a depressurized state; and a substrate mounting table having a plurality of substrate support pins on its upper surface. The substrate mounting table is configured to mount a substrate while providing a gap between the upper surface of the substrate mounting table and the substrate. The substrate heating apparatus further includes a heater that is configured to heat the substrate through the substrate mounting table; a pressure regulator configured to regulate a pressure in the container; a temperature controller configured to control an output of the heater so as to control a temperature of the substrate mounting table; and a pressure controller configured to control the pressure regulator so as to control the pressure in the container. The pressure controller controls the pressure in the container to a first pressure under which heat transmission by gas is possible when the substrate is mounted on the substrate mounting table, and to a second pressure under which there is substantially no heat transmission by gas when a temperature of the substrate reaches a predetermined temperature.

In one embodiment of the present disclosure, the pressure regulator includes a regulated pressure gas supply device configured to introduce gas at a regulated pressure into the container, an exhaust device configured to exhaust gas from the container, a flow controller configured to control a supply of the gas at a regulated pressure into the container, and a pressure control valve configured to control an exhaust of the container.

Also, the first pressure is 1 Torr or higher. Further, the second pressure is 100 mTorr or lower.

The substrate support pin is configured to be height variable and a distance between a lower surface of the substrate and the upper surface of the substrate mounting table is varied by adjusting the height of the substrate support pin. In this case, the substrate support pin has a screw portion being screw-coupled to the substrate mounting table and the distance between the lower surface of the substrate and the upper surface of the substrate mounting table is varied by rotating the substrate support pin.

Also, a plurality of substrate mounting tables is provided so that a plurality of substrates is heated in batches.

In accordance with a second aspect of the present disclosure, a substrate heating method is provided. The substrate heating method includes mounting a substrate on a substrate mounting table having a plurality of substrate support pins on its upper surface in a container maintained in a depressurized state while providing a gap between the upper surface of the substrate mounting table and the substrate; and heating the substrate through a heater that heats the substrate mounting table. A gas pressure in the container is controlled to a first pressure under which heat transmission by gas is possible so as to raise a temperature of the substrate when the substrate is mounted on the substrate mounting table, and the gas pressure in the container is controlled to a second pressure under which there is substantially no heat transmission by gas so as to maintain the temperature of the substrate at a predetermined temperature when the temperature of the substrate reaches the predetermined temperature.

In one embodiment of the present disclosure, the first pressure is 1 Torr or higher. Also, the second pressure is 100 mTorr or lower.

Further, a distance between a lower surface of the substrate and the upper surface of the substrate mounting table is varied by adjusting a height of the substrate support pin.

In accordance with a third aspect of the present disclosure, a substrate processing system is provided. The substrate processing system includes a plurality of processing chambers configured to process a substrate in a depressurized atmosphere; a substrate heating apparatus configured to accommodate the substrate to be processed in the processing chamber and heat the substrate in a depressurized atmosphere before transferring the substrate to the processing chamber; a preliminary vacuum chamber configured to accommodate the substrate to be processed and maintain the substrate in a depressurized atmosphere before transferring the substrate to the processing chamber; and a common transfer chamber configured to be coupled with the plurality of processing chambers, the heating apparatus, and the preliminary vacuum chamber and to have a substrate transfer apparatus for transferring the substrate between the preliminary vacuum chamber and the plurality of processing chambers, the common transfer chamber maintained in a depressurized atmosphere. The substrate is transferred from the preliminary vacuum chamber to the heating apparatus by the substrate transfer apparatus so as to be pre-heated, and the pre-heated substrate is transferred to one of the processing chambers to perform a predetermined process.

In accordance with some embodiments of the present disclosure, upon raising a temperature of a substrate, the substrate is heated through heat transmission by gas by raising the pressure in the container while the substrate is separated from the upper surface of the substrate mounting table. Further, upon maintaining the temperature of the substrate, the pressure in the container is controlled to a pressure under which there is substantially no heat transmission by gas. As such, an in-plane temperature uniformity of the substrate can be secured as well as the temperature thereof can be rapidly raised. Also, without causing an overshoot, the substrate can be maintained at the predetermined temperature with high temperature stability. Also, the substrate is heated up by a resistance heater, thereby avoiding an increase in equipment cost due to the use of lamp heating.

### BRIEF DESCRIPTION OF THE DRAWINGS

FIG. 1 is a schematic plan view showing a substrate processing system with a pre-heating chamber (e.g., a substrate heating apparatus) in accordance with one embodiment of the present disclosure.
FIG. 2 is a schematic diagram showing a substrate transfer apparatus of the substrate processing system of FIG. 1.
FIG. 3 is a longitudinal sectional view showing the pre-heating chamber (e.g., the substrate heating apparatus) in accordance with one embodiment of the present disclosure.
FIG. 4 is a transverse sectional view showing the pre-heating chamber (e.g., the substrate heating apparatus) in accordance with one embodiment of the present disclosure.
FIG. 5 is a sectional view showing main parts of a substrate mounting table used in the pre-heating chamber (e.g., the substrate heating apparatus) in accordance with one embodiment of the present disclosure.
FIG. 6 is a diagram showing a temperature profile of a substrate in the pre-heating chamber (e.g., the substrate heating apparatus) in accordance with one embodiment of the present disclosure.

### DETAILED DESCRPTION

Embodiments will now be described in detail with reference to the accompanying drawings. In the accompanying drawings, the same or corresponding parts are given the same reference numerals.

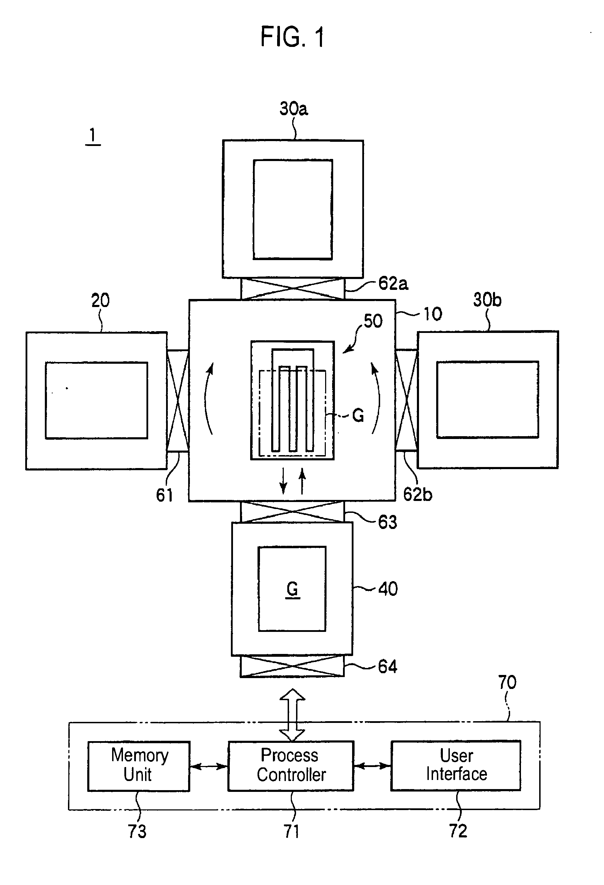

Referring to FIG. 1, there is shown a schematic plan view showing a substrate processing system 1 with a pre-heating chamber (e.g., a substrate heating apparatus) in accordance with one embodiment of the present disclosure. The substrate processing system 1 is configured as a film forming system for forming a film on a rectangular substrate which is used as a substrate, for example, a glass substrate for a flat panel display (FPD) such as a liquid crystal display (LCD), or a solar cell.

As shown in FIG 1, the substrate processing system 1 includes a common transfer chamber 10, a pre-heating chamber 20, processing chambers 30a and 30b, a load lock chamber 40, and a substrate transfer apparatus 50. The pre-heating chamber 20 is connected to the common transfer chamber 10 and constitutes a pre-heating process apparatus for pre-heating a substrate G. The processing chambers 30a and 30b constitute a film forming apparatus for forming a film on the substrate G. The load lock chamber 40 interchanges the substrate G between a substrate accommodating container (not shown) arranged on an atmospheric side and the common transfer chamber 10 maintained in a vacuum. The substrate transfer apparatus 50 transfers the substrate G installed in the common transfer chamber 10. The common transfer chamber 10 has a plane of a rectangular shape. The pre-heating chamber 20, the processing chambers 30a and 30b, and the load lock chamber 40 are connected to corresponding sides of the common transfer chamber 10 through gate valves 61, 62a, 62b, and 63, respectively. A gate valve 64 is disposed on an atmospheric side of the load lock chamber 40. Although the plane of the common transfer chamber 10 has a rectangular shape in this embodiment, it has the shape of, for example, a hexagon or octagon. Also, a pre-heating room, a processing room, or a load lock room is added to the common transfer chamber 10.

In this embodiment, the common transfer chamber 10, the pre-heating chamber 20, and the processing chambers 30a and 30b are made of vacuum chambers and maintained in a predetermined depressurized atmosphere. The load lock chamber 40 serving as a preliminary vacuum chamber is configured such that it interchanges the substrate G between the substrate accommodating container (not shown) arranged on an atmospheric side and the common transfer chamber 10 maintained in a vacuum. The load lock chamber 40 is also configured such that it is switchable between an air atmosphere and a depressurized atmosphere.

The substrate processing system 1 is configured to mount and process a plurality of sheets, for example, three sheets of the substrates G in a horizontal direction perpendicular to a height direction. The plurality of sheets of the substrate G are carried in the load lock chamber 40 from the outer substrate accommodating container through the gate valve 64 by a transfer apparatus (not shown) arranged on an atmospheric side of the container. The carried-in substrates G are sequentially transferred from the load lock chamber 40 to the common transfer chamber 10 through the gate valve 63, from the common transfer chamber 10 to the pre-heating chamber 20 through the gate valve 61, and from the pre-heating chamber 20 to the processing chamber 30a or 30b through the gate valve 62a or 62b. The processed substrates G in the processing chamber 30a or 30b are sequentially transferred from the processing chamber 30a or 30b to the common transfer chamber 10 through the gate valve 62a or 62b and then from the common transfer chamber 10 to the load lock chamber 40 through the gate value 63. Thereafter, the processed substrates G are removed from the load lock chamber 40. Also, in this embodiment, the processing chambers 30a and 30b perform the same film forming process, but in some embodiments they perform different film forming processes. For example, the processing chamber 30a performs a first film forming process and then the processing chamber 30b consecutively performs a second film forming process.

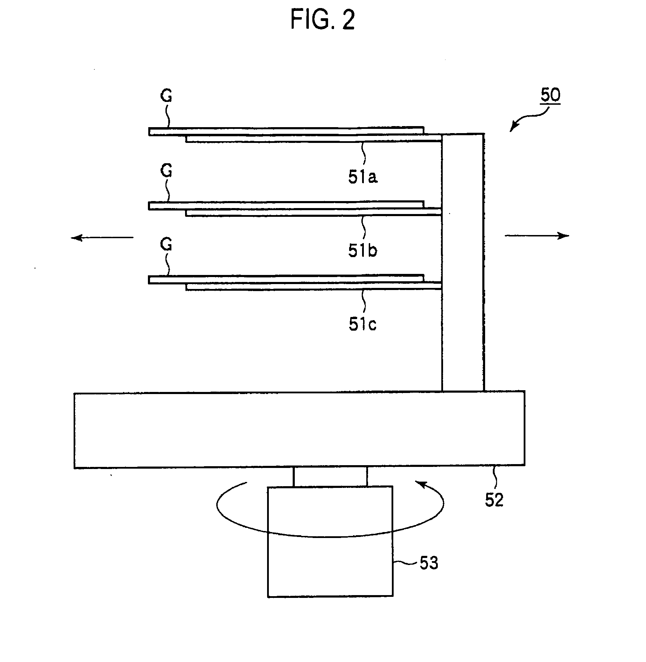

The substrate transfer apparatus 50 is configured to transfer a plurality of sheets, for example, three sheets of the substrates G in batches between the common transfer chamber 10 and the pre-heating chamber 20, and between the processing chambers 30a and 30b and the load lock chamber 40. As shown in FIG. 2, the substrate transfer apparatus 50 is provided with three substrate support arms 51a, 51 b, and 51 c arranged in a vertical direction, which can travel linearly on a rotatable base member 52. Through extending, retracting and rotating operations using the substrate support arms 51a, 51 b, and 51c and the rotatable base member 52, the substrate transfer apparatus 50 accesses the pre-heating chamber 20, the processing chambers 30a and 30b, and the load lock chamber 40. Also, a reference numeral 53 of the substrate transfer apparatus 50 indicates a drive line for realizing the rotating operation of the base member 52.

Respective parts of the substrate processing system 1 are controlled by a control unit 70 (e.g., a computer). The control unit 70 includes a process controller 71 provided with a microprocessor. A user interface 72 and a memory unit 73 are connected to the process controller 71. The user interface 72 is made of a keyboard for enabling an operator to input commands for managing the substrate processing system 1, and a display for visualizing and displaying operating conditions of the substrate processing system 1. The memory unit 73 stores a control program for realizing processes to be performed in the substrate processing system 1 under the control of the process controller 71, or a program or instructions for directing the substrate processing system 1 to perform processes depending upon process conditions. The memory unit 73 includes a memory medium. The program or instructions is stored in the memory medium. The memory medium includes a hard disk, a semiconductor memory, or a portable medium, for example, a CD-ROM (compact disc read only memory), a DVD (digital versatile disc), or a flash memory. In response to instructions from the user interface 72, the program and/or instructions are read out from the memory unit 73 and executed by the process controller 71, thereby performing a desired process in the substrate processing system 1 under the control of the process controller 71.

In the substrate processing system 1 having such a configuration, the gate valve 64 is opened first and then a plurality of sheets, e.g., three sheets, of substrates G to be processed are carried in the load lock chamber 40 (having an atmosphere of air) by a substrate transfer apparatus (not shown) arranged on an atmospheric side. The gate valve 64 is closed to depressurize the atmosphere in the load lock chamber 40. And then, the gate valve 63 is opened and the substrate support arms 51a, 51b, and 51c of the substrate transfer apparatus 50 are extended in batches to the load lock chamber 40, thereby receiving the non-processed substrates G which were carried in the load lock chamber 40. Afterwards, the substrate support arms 51a, 51b, and 51c of the substrate transfer apparatus 50 are retracted into the common transfer chamber 10 and then the gate valve 63 is closed. Subsequently, the base member 52 of the substrate transfer apparatus 50 is rotated to direct the substrate support arms 51a, 51b, and 51c to face the pre-heating chamber 20. And then, the gate valve 61 is opened and the substrate support arms 51a, 51b, and 51c are extended to the pre-heating chamber 20, thereby transferring the non-processed substrates G to the pre-heating chamber 20. Thereafter, the substrate support arms 51a, 51b, and 51c are retracted into the common transfer chamber 10, the gate value 61 is closed, and then a pre-heating of the substrates G is initiated in the pre-heating chamber 20. When the pre-heating is terminated, the gate valve 61 is opened and the substrate support arms 51a, 51b, and 51c are extended to the pre-heating chamber 20, thereby receiving the substrates G for which pre-heating is completed. Thereafter, the substrate support arms 51a, 51b, and 51c are retracted into the common transfer chamber 10 and the gate valve 61 is closed. And then, the base member 52 is rotated to direct the substrate support arms 51a, 51b, and 51c to face the processing chamber 30a or 30b. After that, the gate valve 62a or 62b is opened and the substrate support arms 51a, 51b, and 51c are extended to the processing chamber 30a or 30b, thereby transferring the substrates G for which pre-heating was completed to the processing chamber 30a or 30b. Consequently, the substrate support arms 51a, 51b, and 51c are retracted into the common transfer chamber 10, the gate valve 62a or 62b is closed, and then a process in the processing chamber 30a or 30b is initiated. When the process is terminated, the gate valve 62a or 62b is opened and the substrate support arms 51a, 51b, and 51c are extended to the processing chamber 30a or 30b, thereby receiving the processed substrates G. Continuously, the substrate support arms 51a, 51b, and 51c are retracted into the common transfer chamber 10 and the gate valve 62a or 62b is closed. Subsequently, the base member 52 is rotated to direct the substrate support arms 51a, 51b, and 51c to face the load lock chamber 40. And then, the gate valve 63 is opened and the substrate support arms 51a, 51 b, and 51c are extended to the load lock chamber 40, thereby transferring the processed substrates G to the load lock chamber 40. Afterwards, the substrate support arms 51a, 51b, and 51c are retracted into the common transfer chamber 10, the gate valve 63 is closed, and then the inside of the load lock chamber 40 is changed to an atmosphere of air. Thereafter, the gate valve 64 is opened to remove the processed substrates G from the load lock chamber 40 by the substrate transfer apparatus (not shown) arranged on the atmospheric side.

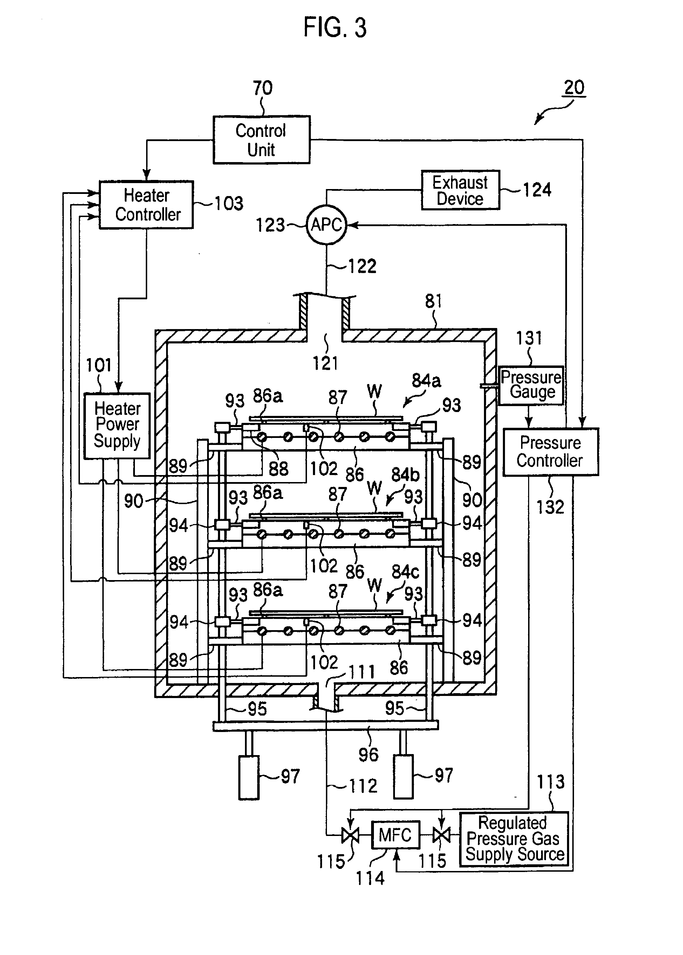

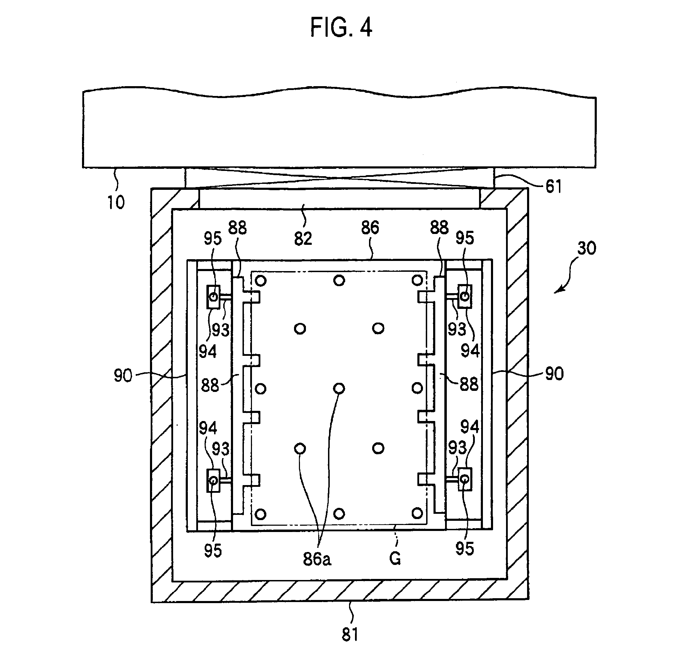

The pre-heating chamber 20 (e.g., a substrate heating apparatus) will be described in detail. FIGS. 3 and 4 are a longitudinal sectional view and a transverse sectional view showing the pre-heating chamber 20, respectively.

The pre-heating chamber 20 includes a container 81. There is provided an opening 82 on a sidewall of the container 81 and the opening 82 can communicate with the common transfer chamber 10 maintained in a vacuum. The opening 82 is opened and closed by the gate valve 61.

In the container 81, three substrate mounting devices 84a, 84b, and 84c are disposed in a vertical direction at regular intervals so as to mount and heat the three sheets of the substrates G.

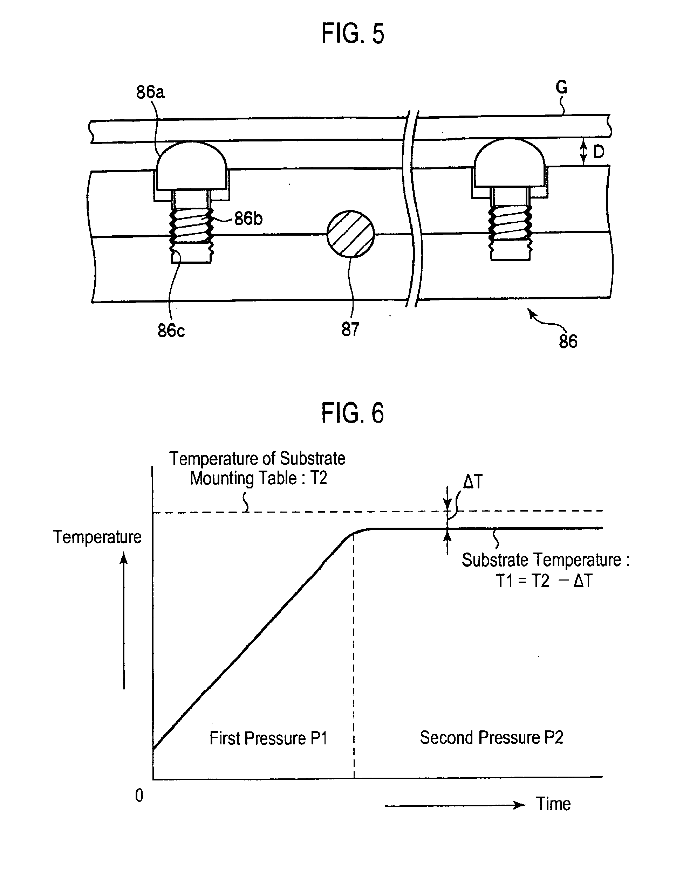

The respective substrate mounting devices 84a, 84b, and 84c have a plane having a rectangular shape corresponding to the substrate G. Each of the substrate mounting devices 84a, 84b, and 84c is provided with a substrate mounting table 86 made of metal, where the substrate G is to be mounted. The substrate mounting table 86 is divided into two parts in a horizontal direction. A heater 87 is disposed between the two divided parts of the substrate mounting table 86. A thickness of each divided part has a thickness of, for example, 15 mm, such that the substrate mounting table 86 will not warp due to heat from the heater 87. A plurality of substrate support pins 86a are disposed on the upper surface of the substrate mounting table 86 so that the substrate G is mounted separately from the upper surface of the substrate mounting table 86. As shown in FIG. 4, for example, thirteen substrate support pins 86a are disposed on the upper surface of the substrate mounting table 86. Each substrate support pin 86a is made of a resin, for example, a polyether ether ketone (PEEK). Also, each substrate support pin 86a has a size of, for example, M3. Also, as shown in FIG. 5, each substrate support pin 86a is provided with a male screw portion 86b. The male screw portion 86b is screw-coupled with a female screw portion 86c formed in the substrate mounting table 86 to rotate the substrate support pin 86a, thereby adjusting a distance D (e.g., a gap shown in FIG. 5) between the substrate G and the upper surface of the substrate mounting table 86. The distance D is set to, for example, 0.8 mm.

The heater 87 disposed on the substrate mounting table 86 is connected to a heater power supply 101. The heater power supply 101 feeds power to the heater 87 and then the heater 87 emits heat, thereby heating up the substrate G on the substrate mounting table 86 to a predetermined temperature. A thermocouple 102 is embedded in close proximity to the upper surface of the substrate mounting table 86. The thermocouple 102 is configured to send a signal to a heater controller 103. The heater controller 103 is configured to transmit a command to the heater power supply 101 in response to the signal from the thermocouple 102, thereby controlling the heating of the heater 87. In this way, the heater controller 103 controls a temperature of the substrate mounting table 86 to the predetermined temperature.

The substrate mounting table 86 of each substrate mounting device 84a, 84b, or 84c is coupled through a connection member 89 to a plurality of frames 90 which are vertically elongated. The frames 90 are disposed on a lower portion of the container 81.

In the respective substrate mounting devices 84a, 84b, and 84c, a pair of comb-shaped substrate elevating members 88 are mounted and disposed on both long-side ends of the upper surface of the substrate mounting table 86, to thereby form a part thereof. The pair of substrate elevating members 88 are configured to support and elevate the substrate G. An upper surface of the substrate elevating member 88 and the upper surface of the substrate mounting table 86 form a plane on the same height level, cooperatively. In this embodiment, the substrate mounting table 86 is made of metal, but ceramics is used instead of the metal.

As shown in FIG. 4, each substrate elevating member 88 of substrate mounting devices 84a, 84b, or 84c is supported by two support bars 93. The support bars 93 are coupled to two connection members 94. Each of the two connection members 94 corresponding to the substrate elevating members 88 arranged in three stages is coupled to two connection shafts 95 which are vertically elongated, respectively. The four connection shafts 95 disposed in pairs on each side extend downward by passing through the lower portion of the container 81, thereby being supported by a support plate 96 which is disposed in a horizontal direction. The support plate 96 is configured to be elevatable by two cylinder devices 97. The substrate elevating members 88 are configured to be elevated as the support plate 96 moves upward and downward.

A gas introducing hole 111 is formed on a lower wall of the container 81. A gas supply line 112 is coupled to the gas introducing hole 111. A regulated pressure gas supply source 113 is coupled to the gas supply line 112. On the gas supply line 112, there are provided a mass flow controller 114 serving as a flow controller for controlling gas flow and opening/closing valves 115 arranged on both sides of the mass flow controller 114. A gas at a regulated pressure, such as Ar gas, N₂ gas and the like, is supplied from the regulated pressure gas supply source 113 to the container 81 through the gas supply line 112.

An exhaust hole 121 is disposed on the ceiling of the container 81 so as to exhaust the inside thereof. An exhaust line 122 is coupled to the exhaust hole 121. An automatic pressure control (APC) valve 123 and an exhaust device 124 are disposed on the exhaust line 122. While a pressure in the container 81 is controlled by the APC valve 123, the container 81 is exhausted by the exhaust device 124.

A pressure gauge 131 is disposed in the container 81 to detect the pressure therein. A detection value of the pressure gauge 131 is outputted to a pressure controller 132. The pressure controller 132 is configured to send a control signal to the mass flow controller 114, the opening/closing valves 115, and the APC valve 123 so that it controls the exhaust and the supply of a gas at a regulated pressure, thereby depressurizing the container 81.

Also, the heater controller 103 and the pressure controller 132 are configured to be controlled by the control unit 70 which controls the whole operation of the substrate processing system 1.

In the pre-heating chamber 20 having such a configuration, the heater controller 103 is configured to control the heater power supply 101 to heat up the substrate mounting table 86 of the respective substrate mounting device 84a, 84b, and 84c to a predetermined temperature. Thereafter, the gate valve 61 is opened to carry in the substrates G supported by the substrate support arms 51a, 51b, and 51c of the substrate transfer apparatus 50 from the opening 82.

And then, the substrate elevating members 88 of the respective substrate mounting devices 84a, 84b, and 84c are elevated by the cylinder devices 97 to receive the substrates G thereon from the substrate support arms 51a, 51b, and 51c. Subsequently, the substrate support arms 51 a, 51 b, and 51c of the substrate transfer apparatus 50 are retracted into the common transfer chamber 10 and the gate valve 61 is closed. Afterwards, the substrate elevating members 88 supporting the substrates G descend toward the substrate mounting tables 86 to mount the substrates G on the substrate supporting pins 86a. In this manner, the substrates G being maintained at room temperature are heated up by the substrate mounting tables 86.

After the gate valve 61 is closed, along with the mounting operation of the substrates G, the mass flow controller 114 is controlled by the pressure controller 132 so that the gas at a regulated pressure is supplied from the regulated pressure gas supply source 113 to the container 81. Thus, the pressure in the container 81 is controlled to a first pressure P1 under which heat transmission by gas is possible. The first pressure P1 is over 1 Torr, preferably over 3 Torr, and more preferably from 10 to 20 Torr, for example, 10 Torr.

At this time, a gap of a distance D is provided between the lower surface of the substrate G and the upper surface of the substrate mounting table 86 by the substrate support pins 86a and the gas pressure is over 1 Torr. Therefore, the substrate G is relatively rapidly heated up by heat transmission of the gas existing in the gap in addition to radiant heat from the substrate mounting table 86. If the substrate G is directly mounted on the substrate mounting table 86, heat transmission to portions of the substrate G directly in contact with the substrate mounting table 86 is different from heat transmission to the remaining portions of the substrate G not in contact therewith due to the microscopic unevenness on the surface of the substrate mounting table 86. Therefore, it is difficult to uniformly heat up the substrate G. On the contrary, by providing the gap between the lower surface of the substrate G and the upper surface of the substrate mounting table 86, heat transmission by gas is uniformly performed on the whole surface of the substrate G, thereby uniformly raising a temperature of the substrate G.

When the temperature of the substrate G reaches a predetermined temperature, the pressure in the container 81 is depressurized up to a second pressure under which there is substantially no heat transmission by gas. The second pressure is below 100 mTorr, preferably 1 to 100 mTorr. For example, the pressure in the container 81 is depressurized up to 100 mTorr under which there is substantially no heat transmission by gas, thereby maintaining the substrate G at the predetermined temperature. At this time, if a temperature of the upper surface of the substrate mounting table 86 is T2, a predetermined temperature T1 of the substrate G is expressed as T1 = T2 - ΔT so that T1 is lower than T2 by ΔT. For example, ΔT is set for 20 to 30 °C. As such, by depressurizing the pressure in the container 81 up to a pressure under which there is substantially no heat transmission by gas, it becomes possible to maintain the substrate G at the predetermined temperature T1 while preserving a uniform temperature distribution without causing an overshoot.

That is, upon raising a temperature, the substrate G is heated up through heat transmission by gas by raising the pressure in the container 81 while the substrate G is separated from the upper surface of the substrate mounting table 86. Further, upon maintaining the temperature, the pressure in the container 81 is controlled to a pressure under which there is substantially no heat transmission by gas. As such, an in-plane temperature uniformity of the substrate G is secured while the temperature thereof is rapidly raised. Also, without causing the overshoot, the substrate G is maintained at the predetermined temperature T1 having high temperature stability.

Further, the substrate G is heated up by the heater 87 of a resistance heating type such that it avoids the increase of equipment cost due to the use of lamp heating.

A temperature profile of the substrate G during the above described process is shown in FIG. 6. The temperature profile of the substrate G is obtained by installing, for example, a thermocouple on the substrate G. A desired temperature profile is realized by appropriately controlling the first pressure P1, the second pressure P2, the temperature T2 of the substrate mounting table 86, and the distance D of the gap between the lower surface of the substrate G and the upper surface of the substrate mounting table 86. In particular, the distance D of the gap can be controlled so that it enables for fine adjustment of the temperature profile. Also, a gap adjustment is enabled in some embodiments by rotating only the substrate support pin 86a having the male screw portion 86b such that the fine adjustment of the temperature profile by the gap adjustment can be very easily realized.

During the heating process of the substrate G, a temperature of the substrate G in some embodiments is not measured directly such that a relationship is obtained between the temperature T2 of the substrate mounting table 86 and the temperature T1 of the substrate G in accordance with the first pressure P1, the second pressure P2, and the distance D of the gap between the lower surface of the substrate G and the upper surface of the substrate mounting table 86. Further, the temperature T2 of the substrate mounting table 86 for obtaining the temperature T1 of the substrate G is set in advance. Furthermore, since a timing transmitted from the first pressure P 1 to the second pressure P2 is not obtained from the actual temperature of the substrate G, in some embodiments a time required for a pressure transition is obtained in advance in accordance with the first pressure P1, the second pressure P2, and the distance D of the gap between the lower surface of the substrate G and the upper surface of the substrate mounting table 86. And then, the pressure transition should be taken when the time required for such a pressure transition has passed.

As such, by depressurizing the pressure in the container 81, the temperature of the substrate G can be maintained at the predetermined temperature such that it is possible to form a film in the approximate same condition even though a time from inserting and receiving the substrate G into and from the pre-heating chamber 20 varies due to transfer condition, etc. depending on whether the processing chamber is the chamber 30a or the chamber 30b.

While some embodiments have been described, various variations and modifications is made without being limited to the foregoing embodiments. For example, the substrate processing system for transferring and processing three sheets of substrates in batches has been described, but one sheet of substrate and/or a plurality of sheets, other than three sheets, of substrates is transferred and processed in batches. Also, the substrate processing system is not limited to FIG. 1, and it is modified to include, for example, three or more processing chambers instead of the two processing chambers.

While certain embodiments have been described, these embodiments have been presented by way of example only, and are not intended to limit the scope of the inventions. Indeed, the novel apparatus, method and system described herein is embodied in a variety of other forms; furthermore, various omissions, substitutions and changes in the form of the embodiments described herein is made without departing from the scope of the inventions. The accompanying claims and their equivalents are intended to cover such forms or modifications which would fall within the scope of the inventions.

## Claims

1. A substrate heating apparatus (20), the apparatus comprising:
a container configured to be maintained in a depressurized state;
a substrate mounting table (86) having a plurality of substrate support pins (86a) on its upper surface, the substrate mounting table (86) configured to mount a substrate while providing a gap between an upper surface of the substrate mounting table (86) and the substrate;
a heater (87) configured to heat the substrate through the substrate mounting table (86);
a pressure regulator configured to regulate a pressure in the container;
a temperature controller configured to control an output of the heater (87) so as to control a temperature of the substrate mounting table (86); and
a pressure controller configured to control the pressure regulator so as to control the pressure in the container,
wherein the pressure controller controls the pressure in the container to a first pressure under which heat transmission by gas is possible when the substrate is mounted on the substrate mounting table (86), and to a second pressure under which there is substantially no heat transmission by gas when a temperature of the substrate reaches a predetermined temperature.

2. The apparatus of Claim 1, wherein the pressure regulator comprises:
a regulated gas pressure supply device configured to introduce gas at a regulated pressure into the container;
an exhaust device (124) configured to exhaust the container;
a flow controller (114) configured to control a supply of the gas at a regulated pressure into the container; and
a pressure control valve configured to control an exhaust of the container.

3. The apparatus of Claim 1 or 2, wherein the first pressure is 1 Torr or higher.

4. The apparatus of one of Claims 1 to 3, wherein the second pressure is 100 mTorr or lower.

5. The apparatus of one of Claims 1 to 4, wherein the substrate support pin (86a) is configured to be height variable and a distance between a lower surface of the substrate and the upper surface of the substrate mounting table (86) is varied by adjusting the height of the substrate support pin (86a).

6. The apparatus of Claim 5, wherein the substrate support pin (86a) has a screw portion being screw-coupled with the substrate mounting table (86) and the distance between the lower surface of the substrate and the upper surface of the substrate mounting table (86) is varied by rotating the substrate support pin (86a).

7. The apparatus of one of Claims 1 to 6, further comprising a plurality of substrate mounting tables so that a plurality of substrates are heated in batches.

8. A method of heating a substrate, the method comprising:
mounting a substrate on a substrate mounting table having a plurality of substrate support pins on its upper surface in a container being maintained in a depressurized state while providing a gap between the upper surface of the substrate mounting table and the substrate; and
heating the substrate through a heater that heats the substrate mounting table,
wherein a gas pressure in the container is controlled to a first pressure under which heat transmission by gas is possible so as to raise a temperature of the substrate when the substrate is mounted on the substrate mounting table, and the gas pressure in the container is controlled to a second pressure under which there is substantially no heat transmission by gas so as to maintain the temperature of the substrate at a predetermined temperature when the temperature of the substrate reaches the predetermined temperature.

9. The method of Claim 8, wherein the first pressure is 1 Torr or higher.

10. The method of Claim 8 or 9, wherein the second pressure is 100 mTorr or lower.

11. The method of one of Claims 8 to 10, wherein a distance between a lower surface of the substrate and the upper surface of the substrate mounting table is varied by adjusting a height of the substrate support pin.

12. A system (1) of processing a substrate, the system comprising:
a plurality of processing chambers (30a, 30b) configured to process a substrate in a depressurized atmosphere;
a substrate heating apparatus (20) according to Claim 1 configured to accommodate the substrate to be processed in the processing chamber and heat the substrate in a depressurized atmosphere before transferring the substrate to the processing chamber;
a preliminary vacuum chamber configured to accommodate the substrate to be processed and maintain the substrate in a depressurized atmosphere before transferring the substrate to the processing chamber; and
a common transfer chamber (10) configured to be coupled with the plurality of processing chambers (30a, 30b), the heating apparatus, and the preliminary vacuum chamber, and to have a substrate transfer apparatus for transferring the substrate between the preliminary vacuum chamber and the plurality of processing chambers (30a, 30b), the common transfer chamber (10) being maintained in a depressurized atmosphere,
wherein the substrate is transferred from the preliminary vacuum chamber to the heating apparatus (20) by the substrate transfer apparatus so as to be pre-heated, and the pre-heated substrate is transferred to one of the processing chambers (30a, 30b) to perform a predetermined process.

13. Use of the system (1) according to claim 12 for processing a substrate, comprising:
accommodating the substrate to be processed in the preliminary vacuum chamber (40) and depressurizing the atmosphere in the preliminary vacuum chamber (40); then
accommodating the substrate to be processed in the substrate heating apparatus (20) according to one of Claims 1 to 7 and heating the substrate in the depressurized atmosphere before transferring the substrate to the processing chambers (30a, 30b); and then
processing the heated substrate in the depressurized atmosphere using the plurality of processing chambers (30a, 30b),
using the common transfer chamber (10) for transferring the substrate between the preliminary vacuum chamber (40), the heating apparatus (20) and the plurality of processing chambers (30a, 30b) with the substrate transfer apparatus (50), while the common transfer chamber (10) is maintained in a depressurized atmosphere, the common transfer chamber (10) being coupled with the plurality of processing chambers (30a, 30b), the heating apparatus (20), and the preliminary vacuum chamber (40),
wherein the substrate transfer apparatus (50) is used for transferring the substrate from the preliminary vacuum chamber (40) to the heating apparatus (20) by so as to be pre-heated, and for transferring the pre-heated substrate to one of the processing chambers (30a, 30b) for performing the predetermined process.
